# EUROPEAN PATENT APPLICATION

(11) **EP 4 694 598 A1**
(43) Date of publication of application: **11.02.2026**
(21) Application number: 24795795.4
(22) Date of filing: 03.04.2024
(51) Int. Cl.: H05K 7/20

(54) **COOLING ASSEMBLY AND COMMUNICATION DEVICE**

(30) Priority: 28.04.2023 CN 202310487571
(71) Applicant: ZTE CORPORATION, Shenzhen, Guangdong 518057 (CN)
(72) Inventor: TANG, Ningfeng, Shenzhen, Guangdong 518057 (CN); LIU, Faju, Shenzhen, Guangdong 518057 (CN)
(74) Representative: Canzler & Bergmeier Patentanwälte Partnerschaft mbB
(86) International application number: PCT/CN2024/085911
(87) International publication number: WO 2024/222414

(57) **Abstract**

Provided in the present disclosure is a cooling assembly. The cooling assembly comprises a shell, a first spoiler and a second spoiler, wherein the first spoiler and the second spoiler are both arranged in the shell, and divide an internal space of the shell into a first medium cavity, a module accommodating cavity and a second medium cavity, the first spoiler is arranged between the first medium cavity and the module accommodating cavity, and the second spoiler is arranged between the second medium cavity and the module accommodating cavity; a first medium through hole in communication with the first medium cavity is formed in the shell, and a second medium through hole in communication with the second medium cavity is formed in the shell; a plurality of first flow guide through holes are formed in the first spoiler so as to enable the first medium cavity to be in communication with the module accommodating cavity; and a plurality of second flow guide through holes are formed in the second spoiler so as to enable the second medium cavity to be in communication with the module accommodating cavity. Further provided in the present disclosure is a communication device.

## Description

### CROSS REFERENCE TO RELATED APPLICATIONS

The present disclosure claims the priority to Chinese Patent Application No. 202310487571.1 filed with the CNIPA on April 28, 2023, the contents of which are incorporated herein by reference in their entirety.

### TECHNICAL FIELD

The present disclosure relates to, but is not limited to, the field of optical devices.

### BACKGROUND

Large-capacity and high-density chip switching capacity is steadily increasing according to the Moore's Law, and Co-Packaged Optics (CPO) devices are generally adopted in the industry for reducing power consumption.

For the CPO devices, a cooling method is crucial to normal operation of the CPO devices. In order to improve heat dissipation efficiency, a liquid cooling method may be adopted to cool the CPO devices. How to achieve liquid cooling well is a technical problem urgently to be solved in the field.

### SUMMARY

The present disclosure provides a cooling assembly, and a communication device including the cooling assembly.

In a first aspect of the present disclosure, there is provided a cooling assembly, including a housing, a first baffle, and a second baffle, the first baffle and the second baffle being both disposed in the housing to divide an inner space of the housing into a first medium cavity, a module accommodating cavity, and a second medium cavity, the first baffle being disposed between the first medium cavity and the module accommodating cavity, and the second baffle being disposed between the second medium cavity and the module accommodating cavity; a first medium through hole communicated with the first medium cavity being formed in the housing, and a second medium through hole communicated with the second medium cavity being formed in the housing; a plurality of first flow guide through holes being formed in the first baffle, so as to communicate the first medium cavity with the module accommodating cavity; and a plurality of second flow guide through holes being formed in the second baffle, so as to communicate the second medium cavity with the module accommodating cavity.

In a second aspect of the present disclosure, there is provided a communication device, including at least one communication function module and the cooling assembly, the at least one communication function module being disposed in the module accommodating cavity.

### BRIEF DESCRIPTION OF DRAWINGS

FIG. 1 is a three-dimensional schematic structural diagram of a cooling assembly according to an implementation of the present disclosure;
FIG. 2 is a three-dimensional schematic structural diagram of a cooling assembly according to another implementation of the present disclosure;
FIG. 3 is a sectional view of a cooling assembly according to an implementation of the present disclosure;
FIG. 4 is a sectional view of a cooling assembly according to another implementation of the present disclosure;
FIG. 5 is a sectional view of a cooling assembly according to still another implementation of the present disclosure;
FIG. 6 is a schematic diagram of a first baffle according to an implementation;
FIG. 7 is a schematic diagram of a first baffle according to another implementation;
FIG. 8 is a three-dimensional exploded schematic diagram of a communication device according to an implementation of the present disclosure;
FIG. 9 is a schematic diagram illustrating a combination manner of a first panel and first connectors;
FIG. 10 is a three-dimensional exploded schematic diagram of a communication device according to another implementation of the present disclosure; and
FIG. 11 is a schematic diagram illustrating another combination manner of a first panel and first connectors.

### DETAIL DESCRIPTION OF EMBODIMENTS

In order to enable those of ordinary skill in the art to better understand the technical solutions of the present disclosure, a cooling assembly and a communication device provided in the present disclosure are described in detail below with reference to the drawings.

Exemplary embodiments will be described more fully below with reference to the drawings, but the exemplary embodiments described herein may be embodied in different forms and should not be interpreted as being limited to the embodiments described herein. Rather, the embodiments are provided to make the present disclosure thorough and complete, and may enable those of ordinary skill in the art to fully understand the scope of the present disclosure.

The embodiments described herein and the features therein can be combined with one another if no conflict is incurred.

The term "and/or" used herein includes any and all combinations of one or more associated listed items.

The terms used herein are merely used to describe specific embodiments, and are not intended to limit the present disclosure. As used herein, "a" and "the" which indicate a singular form are intended to include a plural form, unless expressly stated in the context. It should be further understood that the term "include" and/or the term "be made of" used herein indicates the presence of the described features, integers, operations, elements and/or components, but do not exclude the presence or addition of one or more other features, integers, operations, elements, components and/or combinations thereof.

Unless otherwise defined, all terms (including technical terms and scientific terms) used herein have the same meaning as commonly understood by those of ordinary skill in the art. It should be further understood that terms, such as those defined in commonly used dictionaries, should be interpreted as having a meaning that is consistent with a meaning in the context of the related technology and the background of the present disclosure, and should not be interpreted in an idealized or overly formal sense unless expressly so defined herein.

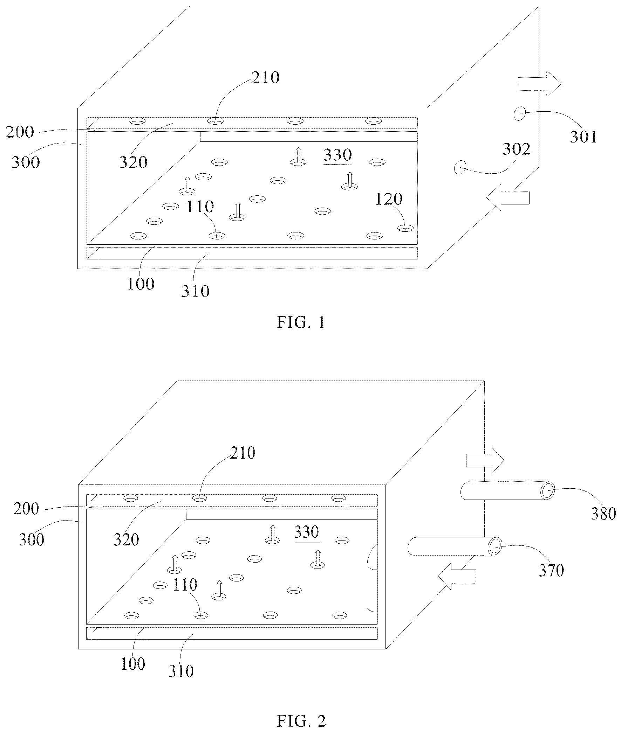

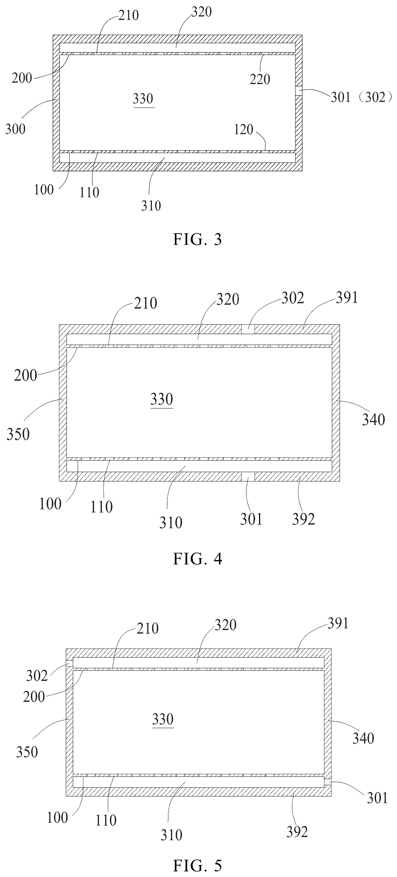

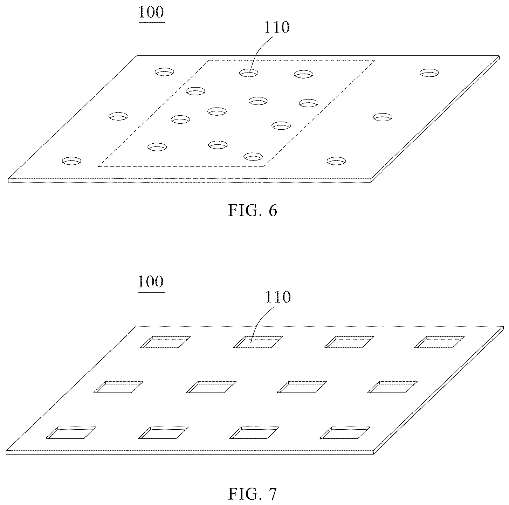

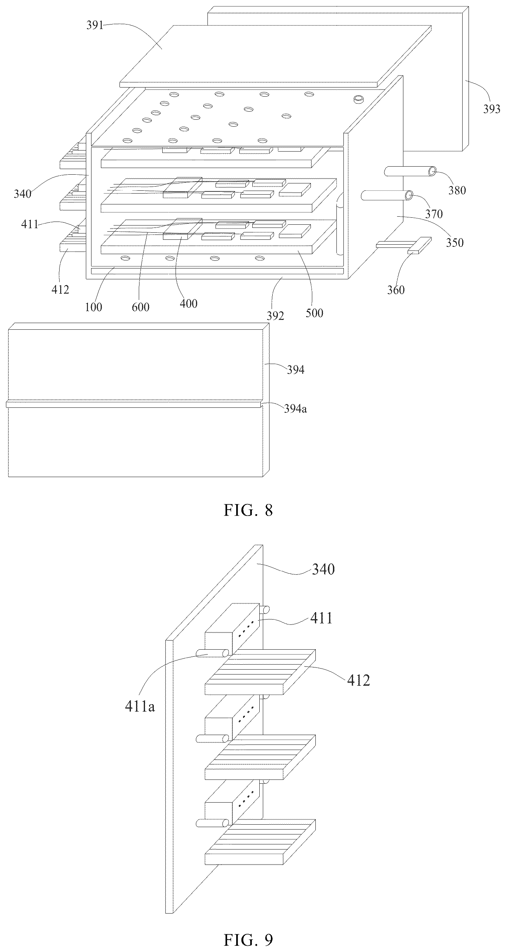

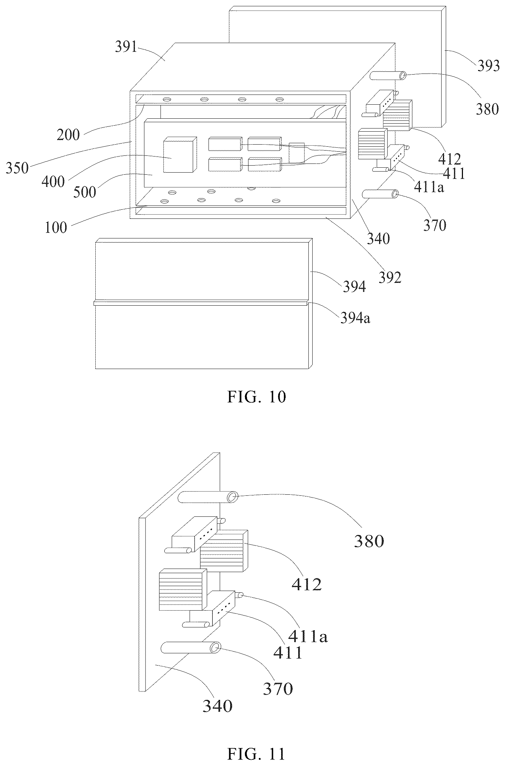

Embodiments of the present disclosure will be described below with reference to FIG. 1 to FIG. 11. FIG. 1 is a three-dimensional schematic structural diagram of a cooling assembly according to an implementation of the present disclosure; FIG. 2 is a three-dimensional schematic structural diagram of a cooling assembly according to another implementation of the present disclosure; FIG. 3 is a sectional view of a cooling assembly according to an implementation of the present disclosure; FIG. 4 is a sectional view of a cooling assembly according to another implementation of the present disclosure; FIG. 5 is a sectional view of a cooling assembly according to still another implementation of the present disclosure; FIG. 6 is a schematic diagram of a first baffle according to an implementation; FIG. 7 is a schematic diagram of a first baffle according to another implementation; FIG. 8 is a three-dimensional exploded schematic diagram of a communication device according to an implementation of the present disclosure; FIG. 9 is a schematic diagram illustrating a combination manner of a first panel and first connectors; FIG. 10 is a three-dimensional exploded schematic diagram of a communication device according to another implementation of the present disclosure; and FIG. 11 is a schematic diagram illustrating another combination manner of a first panel and first connectors.

In an aspect of the present disclosure, a cooling assembly is provided. As shown in FIG. 1 and FIG. 2, the cooling assembly includes a housing 300, a first baffle 100, and a second baffle 200, the first baffle 100 and the second baffle 200 are both disposed in the housing 300 to divide an inner space of the housing 300 into a first medium cavity 310, a module accommodating cavity 330, and a second medium cavity 320, the first baffle 100 is disposed between the first medium cavity 310 and the module accommodating cavity 330, and the second baffle 200 is disposed between the second medium cavity 320 and the module accommodating cavity 330.

As shown in FIG. 3 and FIG. 4, a first medium through hole 301 communicated with the first medium cavity 310 is formed in the housing 300, and a second medium through hole 302 communicated with the second medium cavity 320 is formed in the housing 300.

A plurality of first flow guide through holes 110 are formed in the first baffle 100, so as to communicate the first medium cavity 310 with the module accommodating cavity 330.

A plurality of second flow guide through holes 210 are formed in the second baffle 200, so as to communicate the second medium cavity 320 with the module accommodating cavity 330.

When the cooling assembly is used to cool a communication function module, the communication function module is disposed in the module accommodating cavity 330, a cooling medium (e.g., a cooling liquid) is introduced into the first medium cavity 310 through the first medium through hole 301, the cooling medium in the first medium cavity 310 enters the module accommodating cavity 330 through the first flow guide through holes 110 in the first baffle 100, the communication function module is immersed in the cooling medium to be cooled after the module accommodating cavity 330 is filled with the cooling medium, and the cooling medium absorbing heat from the communication function module enters the second medium cavity 320 through the second flow guide through holes 210 in the second baffle 200, and flows out of the second medium cavity through the second medium through hole 302, thereby finally achieving cooling of the communication function module. In FIG. 1 and FIG. 2, the arrow directions indicate a flow direction of the cooling medium.

The first medium cavity 310 serves as a cooling medium inflow cavity, and the second medium cavity 320 serves as a cooling medium outflow cavity, so that the flow direction of the cooling medium is controllable, and the cooling medium absorbing the heat does not flow back to the first medium cavity 310, which can ensure successful cooling and improve cooling efficiency.

Certainly, the present disclosure is not limited thereto, and the second medium cavity 320 may serve as the cooling medium inflow cavity, and the first medium cavity 310 may serve as the cooling medium outflow cavity.

The number of communication function modules disposed in the module accommodating cavity 330 is not particularly limited in the present disclosure. Generally, different communication function modules are different in power and heat dissipation amount. In order to achieve uniform heat dissipation for various communication function modules which are different in power, optionally, the first baffle 100 is divided into a plurality of first baffle regions, and a distribution density of the first flow guide through holes in at least one first baffle region is different from distribution densities of the first flow guide through holes in the other first baffle regions. The higher the distribution density of the first flow guide through holes, the larger the amount of the cooling medium flowing therethrough, and the better the cooling effect. As shown in FIG. 6, the distribution density of the first flow guide through holes 110 in the first baffle region enclosed with the dashed frame is higher than the distribution densities of the first flow guide through holes 110 in the other first baffle regions.

In order to achieve uniform cooling, optionally, a communication function module with relatively high power is disposed at a position corresponding to the first baffle region with the higher distribution density of the first flow guide through holes, and a communication function module with relatively low power is disposed at a position corresponding to the first baffle region with the lower distribution density of the first flow guide through holes.

Correspondingly, the second baffle 200 may also be divided into a plurality of second baffle regions corresponding to the plurality of first baffle regions, and distribution densities of the second flow guide through holes 210 in the second baffle regions correspond to the distribution densities of the first flow guide through holes in the corresponding first baffle regions.

In the present disclosure, the communication function module may be a pluggable module, and accordingly, the communication function module is connected to an upstream device or a downstream device through a connector. Accordingly, the housing 300 includes a first panel 340 and a second panel 350 disposed opposite to the first panel, and at least one first connector through hole (not shown) is formed in the first panel 340, and is communicated with the module accommodating cavity 330. The connector of the communication function module may be extended out from the first connector through hole. In an alternative implementation, an outer surface of the first panel 340 is a mating surface. A shape of the first connector through hole is not particularly limited in the present disclosure, and may be determined based on a type of the connector. For example, when the connector is an optical connector 411, the shape of the first connector through hole is matched with a shape of the optical connector 411; and when the connector is an electrical connector 412, the shape of the first connector through hole is matched with a shape of the electrical connector 412.

In an alternative implementation, at least one second connector through hole may be provided in the second panel 350, and is communicated with the module accommodating cavity 330. In this way, part of connectors of the communication function module may be extended out from the second connector through hole, so that other communication function modules may be in plug-in connection with the communication function module currently disposed in the cooling assembly.

In an alternative implementation, the cooling assembly further includes an operating member 360, which is disposed on a surface of the second panel 350 facing the outside of the housing. In order to ensure firmness of plug-in connection, a clamping force or a friction force is usually large when the communication function modules are in plug-in connection with each other. In order to separate the connected communication function modules from each other, the operating element 360 for an operator to clamp or hold may be disposed on the outer surface of the second panel 350.

An arrangement position of the first medium through hole 301 is not particularly limited in the present disclosure, as long as the cooling medium can be guided into the first medium cavity 310. For example, the first medium through hole may be disposed in the housing 300 at a position corresponding to the first medium cavity 310.

In an alternative implementation, the first medium through hole 301 may be formed in a part of the first panel 340 which corresponds to the first medium cavity. In another alternative implementation, the first medium through hole 301 may be formed in a part of the second panel 350 which corresponds to the first medium cavity 310.

In another alternative implementation, the first medium through hole 301 is formed in the first panel 340 or the second panel 350, and is communicated with the module accommodating cavity 330, and a first medium guide through hole 120 is formed in the first baffle 100. Correspondingly, the cooling assembly further includes a first tube 370, which connects the first medium through hole 301 to the first medium guide through hole 120. At least part of the first tube 370 is located in the module accommodating cavity 330, and the cooling medium may be introduced into the first tube 370 and guided into the first medium cavity 310 through the first tube 370.

A position of the second medium through hole 302 is also not particularly limited in the present disclosure, as long as the cooling medium can be guided out of the second medium cavity 320. For example, the second medium through hole may be provided in the housing 300 at a position corresponding to the second medium cavity 320.

In an alternative implementation, the second medium through hole 302 may be formed in a part of the first panel 340 which corresponds to the second medium cavity 320, or the second medium through hole 302 may be formed in a part of the second panel 350 which corresponds to the second medium cavity 320.

In another alternative implementation, the second medium through hole 302 is formed in the first panel 340, and is communicated with the module accommodating cavity 330, and a second medium guide through hole 220 is formed in the second baffle 200. Correspondingly, the cooling assembly further includes a second tube 380, which is connected between the second medium through hole 302 and the second medium guide through hole 220 to connect the second medium through hole to the second medium guide through hole 220. At least part of the second tube 380 is located in the module accommodating cavity 330, and the cooling medium in the second medium cavity 320 may be guided out of the cooling assembly through the second tube 380.

In addition, the first medium through hole may be formed in a bottom plate, and the second medium through hole may be formed in a top plate. Illustratively, the housing includes a top plate 391 and a bottom plate 392 disposed opposite to each other, a space between the bottom plate 392 and the first baffle is the first medium cavity, and a space between the top plate 391 and the second baffle is the second medium cavity. The first medium through hole 301 is formed in the bottom plate, and the second medium through hole 302 is formed in the top plate.

In an implementation illustrated by FIG. 3 and FIG. 8, the first medium through hole 301 and the second medium through hole 302 are both disposed in the first panel 340 or the second panel 350 and communicated with the module accommodating cavity 330. Correspondingly, the first medium guide through hole 120 is formed in the first baffle 100, and the first tube 370 connects the first medium through hole 301 to the first medium guide through hole 120, and the second tube 380 is connected between the second medium through hole 302 and the second medium guide through hole 220 to connect the second medium through hole to the second medium guide through hole 220. In this implementation, the cooling medium flows in from the right, and flows out from the right.

In an implementation illustrated by FIG. 4, the first medium through hole 301 is formed in the bottom plate 392, and the second medium through hole 302 is formed in the top plate 391. In this implementation, the cooling medium flows in from the bottom, and flows out from the top.

In an implementation illustrated by FIG. 5, the first medium through hole 301 is formed in the part of the first panel 340 which corresponds to the first medium cavity 310, and the second medium through hole 302 is formed in the part of the second panel 350 which corresponds to the second medium cavity 320. In this implementation, the cooling medium flows in from the right, and flows out from the left.

In the present disclosure, a size of the module accommodating cavity 330 may be determined based on the number of to-be-cooled communication function modules and volumes of the to-be-cooled communication function modules. In order to accommodate more communication function modules and improve device integration, optionally, a volume of the module accommodating cavity 330 is greater than that of the first medium cavity 310, and is also greater than that of the second medium cavity 320.

Shapes of the first flow guide through holes 110 are not particularly limited in the present disclosure. The first flow guide through holes 110 may be circular holes (see FIG. 6), square holes (see FIG. 7), or holes in other shapes.

Similarly, shapes of the second flow guide through holes 210 are also not particularly limited in the present disclosure. The second flow guide through holes 210 may be circular holes, square holes, or holes in other shapes.

In order to facilitate connection of a communication device including the cooling assembly to other communication devices, optionally, as shown in FIG. 8, at least one guide member 394a is provided on an outer surface of the housing.

A structure of the housing 300 is not particularly limited in the present disclosure. For example, as shown in FIG. 8 and FIG. 10, the housing 300 may include the bottom plate 392, the top plate 391 disposed opposite the bottom plate 392, the first panel 340, the second panel 350 disposed opposite the first panel 340, a first side plate 393, and a second side plate 394 disposed opposite the first side plate 393. The first panel 340, the second panel 350, the first side plate 393, and the second side plate 394 are all connected between the top plate 391 and the bottom plate 392 to form a cuboid. Optionally, the guide member 394a may be disposed on the second side plate 394.

Although it is described above that the first tube and the second tube may be disposed on the first panel 340 or the second panel 350, the present disclosure is not limited thereto. At least one of the first tube and the second tube may be disposed on either of the first side plate 393 and the second side plate 394.

In order to facilitate flowing of the cooling liquid, optionally, the first baffle 100 is disposed opposite to the second baffle 200. Further, optionally, the first baffle 100 and the second baffle 200 are arranged in parallel.

In a second aspect of the present disclosure, there is provided a communication device, including at least one communication function module 400 and the cooling assembly provided in the first aspect of the present disclosure, and the communication function module 400 is disposed in the module accommodating cavity 330.

As described above, when the cooling assembly is used to cool the communication function module, the cooling medium (e.g., a cooling liquid) is introduced into the first medium cavity 310 through the first medium through hole 301, the cooling medium in the first medium cavity 310 enters the module accommodating cavity 330 through the first flow guide through holes 110 in the first baffle 100, the communication function module 400 is immersed in the cooling medium to be cooled after the module accommodating cavity 330 is filled with the cooling medium, and the cooling medium absorbing heat from the communication function module 400 enters the second medium cavity 320 through the second flow guide through holes 210 in the second baffle 200, and flows out of the second medium cavity through the second medium through hole 302, thereby finally achieving the cooling of the communication function module.

The first medium cavity 310 serves as the cooling medium inflow cavity, and the second medium cavity 320 serves as the cooling medium outflow cavity, so that the flow direction of the cooling medium is controllable, and the cooling medium absorbing the heat does not flow back to the first medium cavity 310, which can ensure successful cooling and improve cooling efficiency.

In an alternative implementation, the communication device includes a plurality of communication function modules, and the higher the power of the communication function module, the higher the distribution density of the first flow guide through holes in the first baffle.

It should be noted that each communication function module is hermetically connected to a substrate, and each connector is also hermetically connected to the housing.

As described above, the communication function module is connected to an upstream device or a downstream device through the connector. The connector may be the optical connector 411 or the electrical connector 412. The light is supplied to a CPO switch through the optical connector 411. In order to facilitate alignment of the optical connector 411 with a subsequent optical module, corresponding optical connector guide rails 411a are disposed at the periphery of at least one optical connector 411. That is, the optical connector 411 is protruded from the housing, the optical connector guide rails 411a are disposed at the periphery of the optical connector 411 corresponding to the optical connector guide rails 411a, the optical connector guide rails 411a are protruded from the housing, and a direction in which the optical connector guide rails 411a are protruded from the housing is the same as a direction in which the corresponding optical connector 411 is protruded from the housing.

As described above, the housing includes the first panel 340, and the first panel 340 is provided with a plurality of first connector through holes communicated with the module accommodating cavity 330. Correspondingly, the communication device includes at least one optical connector 411 and at least one electrical connector 412, the optical connector 411 is disposed in a first connector through hole corresponding thereto, and the electrical connector 412 is disposed in a first connector through hole corresponding thereto.

As shown in FIG. 9 and FIG. 11, the optical connectors 411 and the electrical connectors 412 are both disposed in the first panel 340 and form a structure similar to an "electro-optical hybrid connector".

Types of the communication function modules 400 and arrangement of the communication function modules 400 in the module accommodating cavity 330 are not particularly limited in the present disclosure.

In an alternative implementation, the communication device may include at least one substrate 500, which is provided thereon with at least one communication function module 400, and is disposed in the module accommodating cavity 330.

As described above, the first baffle 100 and the second baffle 200 may be disposed opposite to each other. In an alternative implementation, the substrate 500 is disposed opposite to the first baffle 100. In another alternative implementation, the substrate 500 is disposed perpendicular to the first baffle 100.

In a case where the communication device includes a plurality of substrates 500, the plurality of substrates 500 may be arranged parallel to each other at intervals.

In an implementation illustrated by FIG. 8, the communication device may be an External Laser Source Form-Factor Pluggable (ELSFP), and accordingly, a plurality of communication function modules 400 may be disposed on each substrate 500. The plurality of communication function modules 400 may be a communication control module, a power supply module, and a laser module respectively. In addition, the communication device may further include output fibers 600. Moreover, in the implementation illustrated by FIG. 8, the first tube 370 and the second tube 380 are both disposed in the second panel 350, and the substrates 500 are parallel to the first baffle 100 and the second baffle 200. As shown in FIG. 9, each first connector through hole is formed in the first panel 340, so as to enable the electrical connectors 412 and the optical connectors 411 to be respectively protruded from the first panel 340. In the implementation illustrated by FIG. 8, the operating member 360 is also disposed on the outer surface of the second panel 350.

In the ELSFP shown in FIG. 8, all the communication function modules 400 (which are the communication control module, the power supply module, and the laser module, respectively) form an external light source, and each communication function module 400 is immersed in a cooling liquid, so that heat dissipated by the communication function module is taken away by the cooling liquid, thereby achieving cooling and heat dissipation. As can be seen, in the implementation illustrated by FIG. 8, a total of three separate light sources are disposed in the module accommodating cavity 330, and each light source includes the communication control module, the power supply module, and the laser module.

An operation process of the ELSFP shown in FIG. 8 is as follows: first, the laser modules and the communication control modules of the ELSFP are powered by an external power supply through the electrical connectors 412, laser emitted from the laser modules is connected to the optical connectors 411 through the output fibers 600, and the light is supplied to the CPO switch through the optical connectors 411. After the communication device is powered, communication and management of a host machine where the communication device is located are started.

In the implementation illustrated by FIG. 10, the communication device may be an ELSFP, and accordingly, a plurality of communication function modules 400 may be disposed on each substrate 500. The plurality of communication function modules 400 may be a communication control module, a power supply module, and a laser module, respectively. In addition, the communication device may further include output fibers 600. Moreover, in the implementation illustrated by FIG. 10, the first tube 370 and the second tube 380 are both disposed in the first panel 340, and the substrates 500 are perpendicular to the first baffle 100 and the second baffle 200. As shown in FIG. 11, the optical connectors 411, the electrical connectors 412, the first tube 370, and the second tube 380 are all disposed in the first panel 340. In this implementation, a communication function module with high power consumption may be arranged closer to liquid inlet cavities of the first medium cavity and the second medium cavity, which can facilitate heat dissipation. In the implementation illustrated by FIG. 10, the second tube 380 may serve as an inlet tube, and the first tube 370 may serve as an outlet tube. With the cooling medium flowing in from the top and flowing out from the bottom, an improvement in heat dissipation efficiency can be facilitated.

As shown in FIG. 11, the first tube 370 and the second tube 380 are disposed in top-and-bottom layout, and correspondingly, the electrical connectors may adopt top-and-bottom structures, which can ensure good Signal Integrity (SI) performance and Power Integrity (PI) performance of the electrical connectors and the substrates.

Exemplary implementations of the present disclosure are disclosed above. Although specific terms are used in the description of the implementations, but the terms are merely interpreted as having general illustrative meanings, rather than for the purpose of limitation. Unless expressly stated, it is apparent to those of ordinary skill in the art that the features, characteristics and/or elements described in connection with a particular embodiment can be used alone or in combination with the features, characteristics and/or elements described in connection with other embodiments. Therefore, it should be understood by those of ordinary skill in the art that various changes in forms and details can be made without departing from the scope of the present disclosure of the appended claims.

## Claims

1. A cooling assembly, comprising a housing, a first baffle, and a second baffle, the first baffle and the second baffle being both disposed in the housing to divide an inner space of the housing into a first medium cavity, a module accommodating cavity, and a second medium cavity, the first baffle being disposed between the first medium cavity and the module accommodating cavity, and the second baffle being disposed between the second medium cavity and the module accommodating cavity;
a first medium through hole communicated with the first medium cavity being formed in the housing, and a second medium through hole communicated with the second medium cavity being formed in the housing;
a plurality of first flow guide through holes being formed in the first baffle, so as to communicate the first medium cavity with the module accommodating cavity; and
a plurality of second flow guide through holes being formed in the second baffle, so as to communicate the second medium cavity with the module accommodating cavity.

2. The cooling assembly of claim 1, wherein the first baffle is divided into a plurality of first baffle regions, and a distribution density of the first flow guide through holes in at least one first baffle region is different from distribution densities of the first flow guide through holes in the other first baffle regions.

3. The cooling assembly of claim 2, wherein the second baffle is divided into a plurality of second baffle regions corresponding to the plurality of first baffle regions, and distribution densities of the second flow guide through holes in the second baffle regions correspond to the distribution densities of the first flow guide through holes in the corresponding first baffle regions.

4. The cooling assembly of any one of claims 1 to 3, wherein the housing comprises a first panel and a second panel disposed opposite to the first panel, and at least one first connector through hole is formed in the first panel, and is communicated with the module accommodating cavity.

5. The cooling assembly of claim 4, wherein at least one second connector through hole is formed in the second panel, and is communicated with the module accommodating cavity; and/or, the cooling assembly further comprises an operating member, which is disposed on a surface of the second panel facing an outside of the housing.

6. The cooling assembly of claim 4, wherein the first medium through hole is formed in the first panel or the second panel, and is communicated with the module accommodating cavity, a first medium guide through hole is formed in the first baffle, the cooling assembly further comprises a first tube, which is connected between the first medium through hole and the first medium guide through hole to connect the first medium through hole to the first medium guide through hole.

7. The cooling assembly of claim 4, wherein the second medium through hole is formed in the first panel or the second panel, and is communicated with the module accommodating cavity, a second medium guide through hole is formed in the second baffle, the cooling assembly further comprises a second tube, which connects the second medium through hole to the second medium guide through hole.

8. The cooling assembly of claim 4, wherein the first medium through hole is formed in a part of the first panel which corresponds to the first medium cavity, or the first medium through hole is formed in a part of the second panel which corresponds to the first medium cavity; and
the second medium through hole is formed in a part of the first panel which corresponds to the second medium cavity, or the second medium through hole is formed in a part of the second panel which corresponds to the second medium cavity.

9. The cooling assembly of any one of claims 1 to 3, wherein the housing comprises a top plate and a bottom plate disposed opposite to each other, a space between the bottom plate and the first baffle is the first medium cavity, and a space between the top plate and the second baffle is the second medium cavity; and
the first medium through hole is formed in the bottom plate, and the second medium through hole is formed in the top plate.

10. The cooling assembly of any one of claims 1 to 3, wherein a volume of the module accommodating cavity is greater than a volume of the first medium cavity, and the volume of the module accommodating cavity is greater than a volume of the second medium cavity.

11. The cooling assembly of any one of claims 1 to 3, wherein at least one guide member is provided on an outer surface of the housing.

12. The cooling assembly of any one of claims 1 to 3, wherein the first baffle is disposed opposite to the second baffle.

13. A communication device, comprising at least one communication function module and the cooling assembly of any one of claims 1 to 12, the communication function module being disposed in the module accommodating cavity.

14. The communication device of claim 13, comprising a plurality of communication function modules, wherein the higher a power of a communication function module, the higher a distribution density of the first flow guide through holes in the first baffle.

15. The communication device of claim 13, comprising at least one optical connector and optical connector guide rails matched with the at least one optical connector, wherein the at least one optical connector is protruded from the housing, the optical connector guide rails are disposed at a periphery of the at least one optical connector corresponding to the optical connector guide rails, the optical connector guide rails are protruded from the housing, and a direction in which the optical connector guide rails are protruded from the housing is the same as a direction in which the at least one optical connector is protruded from the housing.

16. The communication device of claim 13, wherein the housing comprises a first panel, and the first panel is provided with a plurality of first connector through holes communicated with the module accommodating cavity, the communication device comprises at least one optical connector and at least one electrical connector, the at least one optical connector is disposed in a first connector through hole corresponding to the at least one optical connector, and the at least one electrical connector is disposed in a first connector through hole corresponding to the at least one electrical connector.

17. The communication device of any one of claims 13 to 16, comprising at least one substrate, wherein the at least one substrate is disposed in the module accommodating cavity, and the communication function module is disposed on the at least one substrate.
